# FASCICULE DE BREVET EUROPEEN

(11) **EP 3 384 537 B1**
(45) Date de publication et mention de la délivrance du brevet: **30.10.2019**
(21) Numéro de dépôt: 16813092.0
(22) Date de dépôt: 28.11.2016
(51) Int. Cl.: H01L 33/18, H01L 33/08, H01L 33/00, H01L 33/32, H01L 33/06

(54) **DISPOSITIF OPTOELECTRONIQUE COMPORTANT DES STRUCTURES SEMICONDUCTRICES TRIDIMENSIONNELLES EN CONFIGURATION AXIALE**
OPTOELEKTRONISCHE VORRICHTUNG MIT TRIDIMENSIONALEN HALBLEITERSTRUKTUREN IN AXIALER KONFIGURATION
OPTOELECTRONIC APPARATUS COMPRISING TRIDIMENSIONAL SEMICONDUCTOR STRUCTURES IN AXIAL CONFIGURATION

(30) Priorité: 30.11.2015 FR 1561589
(43) Date de publication de la demande: 10.10.2018
(73) Titulaire: Commissariat à l'Energie Atomique et aux Energies Alternatives, 75015 Paris (FR); Aledia, 38040 Grenoble (FR)
(72) Inventeur: ZHANG, Xin, 38000 Grenoble (FR); DAUDIN, Bruno-Jules, 38700 La Tronche (FR); GAYRAL, Bruno, 38950 Saint-Martin-le-Vinoux (FR); GILET, Philippe, 38470 Têche (FR)
(74) Mandataire: GIE Innovation Competence Group
(86) Numéro de dépôt international: PCT/FR2016/053122
(87) Numéro de publication internationale: WO 2017/093646

(56) Documents cités:
- EP-A1- 1 796 180
- EP-A1- 1 796 180
- EP-A2- 2 665 100
- EP-A2- 2 665 100
- WO-A1-2014/138904
- WO-A1-2014/138904
- DAUDIN B ET AL: "Growth, structural and optical properties of GaN/AlN and GaN/GaInN nanowire heterostructures", PHYSICS PROCEDIA, vol. 28, 16 mai 2012 (2012-05-16), pages 5-16, XP028487914, ISSN: 1875-3892, DOI: 10.1016/J.PHPRO.2012.03.662 [extrait le 2012-05-16]
- A-L BAVENCOVE ET AL: "Submicrometre resolved optical characterization of green nanowire-based light emitting diodes;Submicrometre resolved optical characterization of green nanowire-based light emitting diodes", NANOTECHNOLOGY, IOP, BRISTOL, GB, vol. 22, no. 34, 28 juillet 2011 (2011-07-28), page 345705, XP020208850, ISSN: 0957-4484, DOI: 10.1088/0957-4484/22/34/345705
- DAUDIN B ET AL: "Growth, structural and optical properties of GaN/AlN and GaN/GaInN nanowire heterostructures", PHYSICS PROCEDIA, vol. 28, 1 February 2012 (2012-02-01), pages 5-16, XP028487914, ISSN: 1875-3892, DOI: 10.1016/J.PHPRO.2012.03.662 [retrieved on 2012-05-16]
- A-L BAVENCOVE ET AL: "Submicrometre resolved optical characterization of green nanowire-based light emitting diodes;Submicrometre resolved optical characterization of green nanowire-based light emitting diodes", NANOTECHNOLOGY, IOP, BRISTOL, GB, vol. 22, no. 34, 28 July 2011 (2011-07-28) , page 345705, XP020208850, ISSN: 0957-4484, DOI: 10.1088/0957-4484/22/34/345705

## Description

### DOMAINE TECHNIQUE

Le domaine de l'invention est celui des dispositifs optoélectroniques comportant des structures semiconductrices tridimensionnelles, telles que des nanofils ou microfils, adaptées à émettre ou détecter un rayonnement lumineux.

### ÉTAT DE LA TECHNIQUE ANTÉRIEURE

Il existe des dispositifs optoélectroniques comportant des structures semiconductrices tridimensionnelles de type nanofils ou microfils formant par exemple des diodes électroluminescentes. Les nanofils ou microfils comportent habituellement une première portion dopée, par exemple de type n, et une seconde portion dopée du type de conductivité opposé, par exemple de type p, entre lesquelles se situe une portion active comportant au moins un puits quantique.

Ils peuvent être réalisés dans une configuration dite radiale, également appelée cœur/coquille, dans laquelle la portion active et la seconde portion dopée p sont formées à la périphérie de la première portion dopée n. Ils peuvent également être réalisés dans une configuration dite axiale, dans laquelle la portion active et la seconde portion dopée p ne recouvrent pas la périphérie de la première portion dopée n mais s'étendent essentiellement suivant un axe longitudinal de croissance épitaxiale.

Les nanofils ou microfils en configuration axiale ont une surface d'émission inférieure à celle des fils en configuration radiale, mais présentent l'avantage d'être réalisés en un matériau semiconducteur de meilleure qualité cristalline offrant ainsi un rendement quantique interne supérieur, du fait notamment d'une meilleure relaxation des contraintes aux interfaces entre les portions semiconductrices. Dans le cas de puits quantiques réalisés en InGaN, les nanofils ou microfils en configuration axiale permettent ainsi d'incorporer davantage d'indium pour émettre par exemple dans le rouge ou le vert.

A titre d'exemple, la publication de Bavencove et al., intitulée Submicrometre resolved optical characterization ofgreen nanowire-based light emitting diodes, Nanotechnoloy 22 (2011) 345705, décrit un exemple de dispositif optoélectronique à nanofils en configuration axiale, dans lequel une partie supérieure des secondes portions dopées p est en contact mutuel, et sur laquelle repose une électrode de polarisation transparente au rayonnement lumineux émis par les fils. Chaque portion active présente ici un diamètre moyen sensiblement identique à celui de la première portion dopée N et comporte des puits quantiques multiples. Les fils sont réalisés à base de GaN par épitaxie par jets moléculaires. Il existe cependant un besoin pour développer des dispositifs optoélectroniques comportant des structures semiconductrices tridimensionnelles du type nanofils ou microfils présentant un rendement optique amélioré.

Les documents EP 2 665 100 A2, EP 1 796 180 A1 et WO 2014/138904 A1 divulguent d'autres exemples de dispositifs optoélectroniques de l'art antérieur.

### EXPOSÉ DE L'INVENTION

L'invention a pour objectif de remédier au moins en partie aux inconvénients de l'art antérieur, et plus particulièrement de proposer un dispositif optoélectronique comportant au moins une structure semiconductrice tridimensionnelle dont le rendement optique est amélioré. Pour cela, l'objet de l'invention est un dispositif optoélectronique selon la revendication 1.

Selon l'invention, le puits quantique de la portion active présente un diamètre moyen supérieur à celui de ladite première portion dopée, et est recouvert latéralement par une couche de passivation.

De plus, le dispositif optoélectronique comporte une pluralité de structures semiconductrices tridimensionnelles s'étendant de manière sensiblement parallèle les unes aux autres, dont les portions actives sont en contact mutuel.

Certains aspects préférés mais non limitatifs de ce dispositif optoélectronique sont les suivants.

Le ou les puits quantiques de chaque portion active sont séparés du ou des puits quantiques de la portion active adjacente par les couches de passivation en contact mutuel.

Le dispositif optoélectronique peut présenter une densité de premières portions dopées par unité de surface du substrat comprise entre 0,5.10¹⁰ cm⁻² et 1,5.10¹⁰ cm⁻², les premières portions dopées étant distinctes les unes des autres et présentant un diamètre moyen sensiblement constant suivant l'axe longitudinal.

La couche de passivation peut présenter une épaisseur moyenne supérieure ou égale à 2nm, et de préférence comprise entre 2nm et 15nm.

La première portion dopée peut être réalisée en un composé III-V, un composé II-VI, ou un élément ou composé IV, la couche de passivation pouvant être réalisée en un composé comportant au moins un élément présent dans le composé de la première portion dopée.

Le diamètre moyen du ou des puits quantiques peut être compris entre 115% et 250% du diamètre moyen de la première portion dopée.

La portion active peut comporter un unique puits quantique s'étendant continûment entre les première et seconde portions dopées, et ledit unique puits quantique étant recouvert latéralement par la couche de passivation.

La portion active peut comporter plusieurs couches formant des puits quantiques ou boîtes quantiques intercalées entre des couches barrières, recouvertes latéralement par la couche de passivation.

La structure semiconductrice tridimensionnelle peut être réalisée en un matériau comportant majoritairement un composé III-N, la couche de passivation étant de préférence réalisée en un composé choisi parmi le GaN, l'AlGaN et l'AlN.

L'invention porte également sur un procédé de réalisation d'un dispositif optoélectronique selon la revendication 1, dans lequel la ou les structures semiconductrices tridimensionnelles sont formées par épitaxie par jets moléculaires.

Le procédé peut comporter des étapes de formation par croissance épitaxiale d'une pluralité de structures semiconductrices tridimensionnelles dans lesquelles :
i) on forme les premières portions dopées, qui s'étendent à partir d'une face du substrat suivant l'axe longitudinal ;
ii) on forme les portions actives comportant au moins un puits quantique, qui s'étendent à partir des premières portions dopées suivant l'axe longitudinal ;
   - lors de l'étape ii), le puits quantique de chaque portion active est formé de manière à présenter un diamètre moyen supérieur à celui de la première portion dopée ;
   - on forme en outre une couche de passivation recouvrant latéralement le puits quantique. La formation de la couche de passivation peut être concomitante à la formation du puits quantique.

La structure semiconductrice tridimensionnelle peut comporter majoritairement un composé III-V, l'étape ii) de formation de la portion active étant effectuée à une valeur T2 de température de croissance épitaxiale inférieure à une valeur T1 lors de l'étape i) de formation de la première portion dopée, et de préférence comprise entre 600°C et 680°C, et étant effectuée à un rapport entre les flux atomiques des éléments III sur les éléments V compris entre 0,33 et 0,60. Ainsi, de manière surprenante, on obtient un dispositif optoélectronique dont les diodes filaires présentent un spectre d'émission dont la largeur à mi-hauteur du pic d'émission est réduite. Cela se traduit par un taux d'élargissement du diamètre moyen du ou des puits quantiques, et donc de la portion active, vis-à-vis de celui de la première portion dopée, compris entre 115% et 250%.

L'étape i) de formation de la première portion dopée peut comporter une sous-étape de nucléation du composé III-V effectuée à une température de croissance de telle sorte qu'une densité de premières portions dopées par unité de surface du substrat est comprise entre 0,5.10¹⁰ cm⁻² et 1,5.10¹⁰ cm⁻².

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1 est une vue schématique en coupe d'un dispositif optoélectronique selon un premier mode de réalisation, comportant des structures semiconductrices tridimensionnelles en configuration axiale dont la portion active est élargie et passivée ;
la figure 2 est une vue schématique en coupe d'un autre exemple de structure semiconductrice tridimensionnelle en configuration axiale, dont la portion active comporte un unique puits quantique ;
la figure 3 est un diagramme représentant un exemple d'évolution du taux d'élargissement R_{D} de la portion active en fonction de la température de croissance T et du rapport In/III nominal ;
la figure 4 illustre un exemple d'évolution de la proportion atomique d'indium et de gallium suivant une coupe transversale de la portion active de la structure semiconductrice tridimensionnelle représentée sur la figure 2, à partir d'une analyse dispersive en énergie (EDX, pour *energy dispersive X-ray spectrometry* en anglais) ;
la figure 5 est une vue schématique en coupe d'un dispositif optoélectronique selon un second mode de réalisation, comportant des structures semiconductrices tridimensionnelles en configuration axiale, dont les portions actives sont en contact mutuel ;
la figure 6a est une vue schématique en coupe d'une variante de structure semiconductrice tridimensionnelle en configuration axiale, dont la portion active comporte des puits quantiques multiples sous forme de couches ;
et la figure 6b est une vue schématique en coupe d'une autre variante de structure semiconductrice tridimensionnelle en configuration axiale, dont la portion active comporte des puits quantiques multiples sous forme de boîtes quantiques.

### EXPOSÉ DÉTAILLÉ DE MODES DE RÉALISATION PARTICULIERS

Dans la description suivante, le premier mode de réalisation est un exemple utile à la compréhension de l'invention mais ne faisant pas partie de celle-ci, alors que le deuxième mode de réalisation est un mode de réalisation selon l'invention. L'invention est définie par les revendications.

Sur les figures et dans la suite de la description, les mêmes références représentent les éléments identiques ou similaires. De plus, les différents éléments ne sont pas représentés à l'échelle de manière à privilégier la clarté des figures. Par ailleurs, les termes « sensiblement », « approximativement », « environ » s'entendent « à 10% près ».

L'invention porte sur un dispositif optoélectronique comportant des structures semiconductrices tridimensionnelles adaptées à former des diodes électroluminescentes ou des photodiodes.

Les structures semiconductrices tridimensionnelles présentent une forme allongée suivant un axe longitudinal Δ, c'est-à-dire dont la dimension longitudinale suivant l'axe longitudinal Δ est supérieure aux dimensions transversales. Les structures tridimensionnelles sont alors appelées « fils », « nanofils » ou « microfils ». Les dimensions transversales des fils, c'est-à-dire leurs dimensions dans un plan orthogonal à l'axe longitudinal Δ, peuvent être comprises entre 5nm et 5µm, par exemple comprises entre 10nm et 500nm, et de préférence comprises entre 30nm et 300nm. La hauteur des fils, c'est-à-dire leur dimension longitudinale suivant l'axe longitudinal Δ, est supérieure aux dimensions transversales, par exemple 2 fois, 5 fois et de préférence au moins 10 fois supérieure.

La section droite des fils, dans un plan orthogonal à l'axe longitudinal Δ, peut présenter différentes formes, par exemple une forme circulaire, ovale, polygonale par exemple triangulaire, carrée, rectangulaire voire hexagonale. On définit ici le diamètre comme étant une grandeur associée au périmètre du fil au niveau d'une section droite. Il peut s'agir du diamètre d'un disque présentant la même surface que la section droite du fil. Le diamètre local est le diamètre du fil à une hauteur donnée de celui-ci suivant l'axe longitudinal Δ. Le diamètre moyen est la moyenne, par exemple arithmétique, des diamètres locaux le long du fil ou d'une portion de celui-ci.

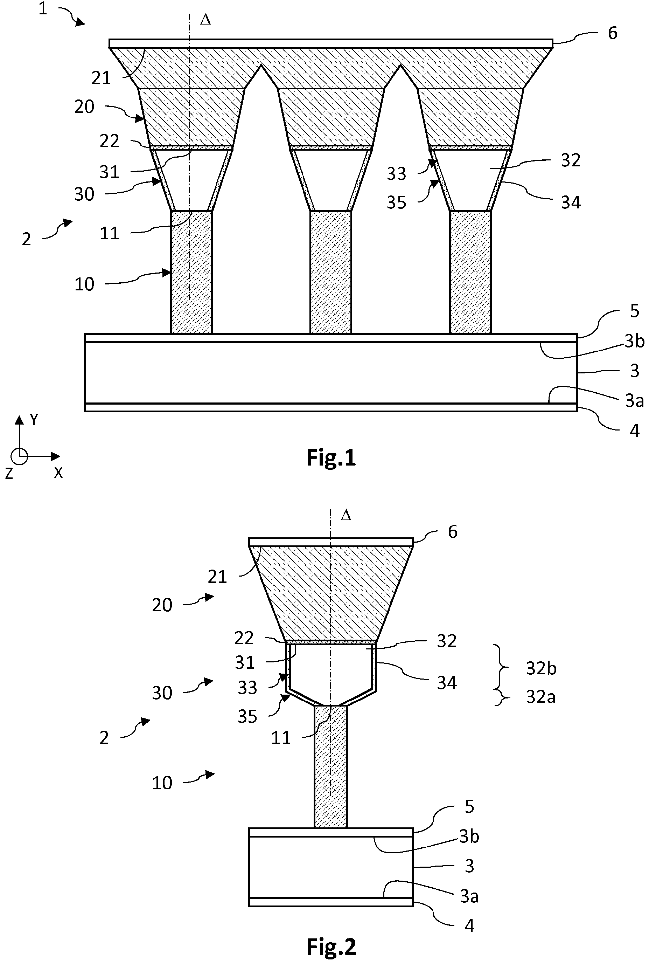

La figure 1 illustre schématiquement une vue partielle en coupe d'un premier mode de réalisation d'un dispositif optoélectronique 1 comportant des structures semiconductrices tridimensionnelles 2 formant des diodes électroluminescentes filaires axiales.

On définit ici et pour la suite de la description un repère orthonormé tridimensionnel (X,Y,Z), où le plan (X,Y) est sensiblement parallèle au plan d'un substrat du dispositif optoélectronique, l'axe Z étant orienté suivant une direction orthogonale au plan du substrat.

Dans cet exemple, le dispositif optoélectronique 1 comporte :
- un substrat 3, par exemple réalisé en un matériau semiconducteur, présentant deux faces, dite arrière 3a et avant 3b, opposées l'une à l'autre ;
- une première électrode de polarisation 4, ici en contact avec la face arrière 3a du substrat ;
- une couche de nucléation 5, réalisée en un matériau adapté à la croissance épitaxiale des structures semiconductrices tridimensionnelles, recouvrant la face avant 3b du substrat ;
- des structures semiconductrices tridimensionnelles 2, ici sous forme de fils, qui s'étendent à partir de la couche de nucléation 5 suivant un axe longitudinal Δ orienté de manière sensiblement orthogonale au plan (X,Y) de la face avant 3b du substrat 3, chaque fil 2 comportant une première portion dopée 10 en contact avec la couche de nucléation 5, une portion active 30 ainsi qu'une seconde portion dopée 20 disposées dans le prolongement de la première portion dopée 10 suivant l'axe longitudinal Δ ;
- une couche de seconde électrode de polarisation 6, en contact avec chaque seconde portion dopée 20.

Chaque structure semiconductrice tridimensionnelle 2 forme ici une diode électroluminescente filaire en configuration axiale, adaptée à émettre un rayonnement lumineux au niveau de sa portion active. Les fils 2 sont dits en configuration axiale dans la mesure où chaque portion active 30 revêt essentiellement une face supérieure 11 de la première portion dopée 10 sensiblement orthogonale à l'axe longitudinal Δ, et s'étend suivant l'axe longitudinal Δ. De plus, la seconde portion dopée 20 revêt essentiellement une face supérieure 31 de la portion active 30 sensiblement orthogonale à l'axe longitudinal Δ, et s'étend suivant l'axe longitudinal Δ. Les fils 2 présentent donc une configuration axiale qui se distingue ainsi de la configuration cœur/coquille mentionnée précédemment.

Chaque fil 2 est réalisé à partir d'au moins un matériau semiconducteur, qui peut être choisi parmi les composés III-V comportant au moins un élément de la colonne III et au moins un élément de la colonne V du tableau périodique ; les composés II-VI comportant au moins un élément de la colonne II et au moins un élément de la colonne VI ; ou les éléments ou composés IV comportant au moins un élément de la colonne IV. A titre d'exemple, des composés III-V peuvent être des composés III-N, tels que GaN, InGaN, AlGaN, AlN, InN ou AlInGaN, voire des composés comportant un élément de la colonne V du type arsenic ou phosphore, par exemple l'AsGa ou l'InP. Par ailleurs, des composés II-VI peuvent être CdTe, HgTe, CdHgTe, ZnO, ZnMgO, CdZnO ou CdZnMgO. Enfin, des éléments ou composés IV peuvent être utilisés, tels que Si, C, Ge, SiC, SiGe, ou GeC. Le matériau semiconducteur de la structure tridimensionnelle peut comporter un dopant, par exemple du silicium assurant un dopage de type n d'un composé III-N, ou du magnésium assurant un dopage de type p.

La portion active 30 est la portion au niveau de laquelle est émis l'essentiel du rayonnement lumineux du fil. Elle comprend au moins un puits quantique, réalisé en un second matériau présentant une énergie de bande interdite inférieure à celle de la première portion dopée et de la seconde portion dopée, correspondant à une zone émissive de la portion active. Le puits quantique peut être épais ou être formé d'au moins une couche fine disposée de préférence entre deux couches barrières, améliorant ainsi le confinement des porteurs de charge. Le second matériau comprend le composé III-V, II-VI ou IV des première et seconde portions dopées dans lequel est incorporé au moins un élément supplémentaire. A titre d'exemple, dans le cas d'un fil réalisé à base de GaN, le second matériau formant le puits quantique est préférentiellement de l'InGaN. Le pourcentage atomique de l'élément supplémentaire est fonction des propriétés optiques recherchées et du spectre d'émission du fil. Comme détaillé plus loin, la portion active peut être formée d'un unique puits quantique en une portion d'un matériau semiconducteur s'étendant entre les première et seconde portions dopées. Alternativement, elle peut comporter plusieurs puits quantiques sous forme de couches ou de boîtes intercalées entre des couches barrières.

Selon un mode de réalisation préféré, chaque fil 2 est réalisé à base de GaN, le ou les puits quantiques étant réalisés en InGaN. La première portion dopée 10 peut être formée de GaN, et être dopée du premier type de conductivité, par exemple de type n, notamment par du silicium. La hauteur de la première portion dopée peut être comprise entre 100nm et 10µm, par exemple comprise entre 500nm et 5µm, et notamment être sensiblement égale à 1µm.

La portion active 30 peut comprendre un ou plusieurs puits quantiques, par exemple réalisés en InGaN. La portion active peut comprendre un unique puits quantique qui s'étend continûment suivant l'axe longitudinal Δ entre les première et seconde portions dopées 10, 20. Alternativement, elle peut comprendre des puits quantiques multiples et est alors formée d'une alternance, suivant l'axe longitudinal Δ, de puits quantiques réalisés par exemple en InGaN, et de couches barrières réalisées par exemple en GaN. La hauteur de la portion active peut être comprise entre 20nm et 500nm, par exemple comprise entre 50nm et 200nm, et notamment être sensiblement égale à 100nm.

La seconde portion dopée 20 peut être formée de GaN, et être dopée du second type de conductivité opposé au premier, par exemple de type p, notamment par du magnésium. La hauteur de la seconde portion dopée peut être comprise entre 50nm et 5µm, par exemple comprise entre 100nm et 1µm et notamment être de l'ordre de quelques dizaines ou centaines de nanomètres de manière à limiter la résistance série associée à cette portion dopée. La hauteur peut ainsi être sensiblement égale à 400nm.

La seconde portion dopée 20 peut comprendre une couche de blocage d'électrons 22 située à l'interface avec la portion active 30. La couche de blocage d'électrons peut être formée d'un composé ternaire III-N, par exemple de l'AlGaN ou de l'AlInN, avantageusement dopée p. Elle permet d'accroître le taux de recombinaisons radiatives au sein de la portion active.

La seconde électrode de polarisation 6 est en contact avec une face supérieure 21 de la portion dopée 20 et est adaptée à assurer l'injection de porteurs de charge dans les fils 2. Elle est réalisée en un matériau sensiblement transparent vis-à-vis du rayonnement lumineux émis par le fil, par exemple de l'oxyde d'indium étain (ITO, pour *Indium Tin Oxide*). Elle présente une épaisseur de quelques nanomètres à quelques dizaines ou centaines de nanomètres.

Par ailleurs, chaque fil 2 repose sur un substrat 3 dont la face supérieure 3b peut être revêtue de la couche de nucléation 5. La couche de nucléation 5 est réalisée en un matériau favorisant la nucléation et la croissance des fils, par exemple le nitrure d'aluminium (AlN) ou l'oxyde d'aluminium (Al₂O₃), le nitrure de magnésium (MgₓN_{y}), le nitrure ou le carbure d'un métal de transition ou tout autre matériau adapté. L'épaisseur de la couche de nucléation peut être de l'ordre de quelques nanomètres ou quelques dizaines de nanomètres. Dans cet exemple, la couche de nucléation est en AlN.

Le substrat 3 peut être une structure monobloc ou être formé d'un empilement de couches tel qu'un substrat du type SOI (acronyme de *Silicon On Insulator*, en anglais). Le substrat peut être en un matériau semiconducteur, par exemple en silicium, en germanium, en carbure de silicium, ou en un composé III-V ou II-VI. Il peut également être en un matériau métallique ou en un matériau isolant. Il peut comporter une couche de graphène, de sulfure ou séléniure de molybdène (MoS2, MoSe2), ou de tout autre matériau équivalent. Dans cet exemple, le substrat est en silicium monocristallin fortement dopé de type n.

La première électrode de polarisation 4 est en contact avec le substrat 3, ici électriquement conducteur, par exemple au niveau de sa face arrière 3a. Elle peut être réalisée en aluminium ou en tout autre matériau adapté.

Ainsi, lorsqu'une différence de potentiel est appliquée aux fils 2 dans un sens direct par l'intermédiaire des deux électrodes de polarisation, les fils 2 émettent un rayonnement lumineux dont le spectre d'émission présente un pic d'intensité à une longueur d'onde dépendant principalement de la composition du ou des puits quantiques.

Comme l'illustre la figure 1, la portion active 30 comporte au moins un puits quantique 32 dont le diamètre moyen est supérieur au diamètre moyen de la première portion dopée 10. La première portion dopée 10 présente ici un diamètre moyen approximativement égal au diamètre local. Le diamètre moyen de la première portion dopée 10 peut être compris entre 5nm et 5µm, par exemple compris entre 10nm et 100nm, et notamment être sensiblement égal à 50nm. Dans le cas d'un unique puits quantique, le diamètre moyen est la moyenne des diamètres locaux de ce même puits quantique suivant l'axe longitudinal Δ. Dans le cas de puits quantiques multiples se présentant sous forme de couches ou de boîtes, le diamètre local est le diamètre d'une couche de puits quantique ou le diamètre cumulé des boîtes quantiques situées au niveau d'une même section droite. Le diamètre moyen est la moyenne des diamètres locaux des différentes couches ou boîtes quantiques.

La portion active 30 comporte alors un diamètre local supérieur au diamètre moyen de la première portion dopée 10. Dans l'exemple de la figure 1, elle présente également un diamètre moyen qui croît à mesure que l'on s'éloigne de la première portion dopée 10, à partir d'une première valeur sensiblement égale au diamètre local de la première portion dopée 10 au niveau de sa face supérieure 11, jusqu'à une seconde valeur maximale au niveau de l'interface entre la portion active 30 et la seconde portion dopée 20. La portion active 30 présente alors un diamètre moyen supérieur à celui de la première portion dopée 10.

Cela se traduit par un élargissement de chaque fil 2 dans le plan (X,Y) au niveau de la portion active 30. Le diamètre moyen de la portion active 30 peut être compris entre 110% et 400% du diamètre moyen de la première portion dopée 10, et de préférence compris entre 115% et 250% de manière à présenter une meilleure qualité cristalline et/ou un spectre d'émission dont la largeur à mi-hauteur (FWHM, pour *Full Width at Half Maximum* en anglais) du pic d'émission est réduite. A titre d'exemple, pour un diamètre moyen de la première portion dopée 10 de 50nm environ, le diamètre moyen de la portion active 30 peut être égal à 75nm environ.

La seconde portion dopée 20 s'étend à partir de la portion active 20 suivant l'axe longitudinal Δ du fil 2. Dans cet exemple, le diamètre local de la seconde portion dopée 20 augmente progressivement, jusqu'à venir au contact de la seconde portion dopée 20 des fils 2 voisins et ainsi provoquer la coalescence des fils 2 au niveau des secondes portions dopées 20. Ainsi, le diamètre local augmente d'une valeur sensiblement égale au diamètre local de la portion active 30 au niveau de sa face supérieure 31 jusqu'à une valeur correspondant par exemple au contact avec les secondes portions dopées 20 voisines. A titre d'exemple, pour un diamètre moyen de 50nm environ pour la première portion dopée 10 et de 75nm environ pour la portion active 30, le diamètre moyen de la seconde portion dopée 20 peut être égale à 100nm environ. De manière alternative, le diamètre local de la seconde portion dopée 20 peut être sensiblement constant le long de l'axe longitudinal Δ et ainsi être sensiblement égal à la valeur du diamètre local de la portion active 30 au niveau de sa face supérieure 31.

De plus, la portion active 30 comporte une couche de passivation 34, également appelée coquille de passivation, située au niveau de sa paroi latérale 35. La couche de passivation 34 recouvre la bordure latérale 33 du ou des puits quantiques 32, de préférence continûment le long de leur circonférence. La bordure latérale 33 du puits quantique 32 est la surface du puits quantique, dans un plan transversal (X,Y), située en regard de la paroi latérale 35 de la portion active 30. La couche de passivation 34 présente une épaisseur qui dépend de la constante diélectrique ou de l'énergie de bande interdite du matériau formant la couche de passivation, de telle sorte que la couche de passivation permet de limiter l'effet d'éventuels états de surface liés par exemple à l'élargissement de la portion active, ces états de surface pouvant conduire à des recombinaisons non radiatives dans le ou les puits quantiques. La couche mince de passivation peut ainsi présenter une épaisseur comprise entre 2nm et 15nm, par exemple comprise entre 5nm et 10nm.

La couche de passivation 34 peut ainsi être réalisée en un matériau choisi parmi les composés III-V, les composés II-VI, les composés ou éléments IV, voire les matériaux diélectriques tels que les nitrures et oxydes d'aluminium (Al2O3) ou de silicium (Si02, SI3N4). A titre d'exemple, dans le cas de première et seconde portions dopées réalisées en GaN et un puits quantique en InGaN, la couche de passivation peut être réalisée en GaN, en AlN ou en AlGaN, par exemple non intentionnellement dopé.

De préférence, l'épaisseur et le matériau de la couche de passivation 34 sont choisis de sorte que la couche de passivation présente une résistance électrique ou une énergie de bande interdite supérieure à celle des puits quantiques, de manière à optimiser le transport des porteurs de charge en direction du ou des puits quantiques. A titre d'exemple, la couche de passivation peut être formée en AlN, AlGaN voire en GaN d'une épaisseur comprise entre 2nm et 15nm.

Lorsque le matériau formant les première et seconde portions dopées 10, 20 est un composé III-V ou un composé II-VI, le matériau formant la couche de passivation 34 est également un composé III-V ou un composé II-VI respectivement, et peut comprendre le même élément de la colonne V ou VI que le matériau des première et seconde portions dopées. A titre d'exemple, dans le cas de première et seconde portions dopées réalisées en GaN et un puits quantique en InGaN, la couche de passivation peut être réalisée en GaN, en AlN, ou en AlGaN.

Comme il sera détaillé plus loin, la couche de passivation 34 est avantageusement formée de manière concomitante à la formation du ou des puits quantiques 32. Elle vient ainsi limiter les états de surface en bordure latérale du ou des puits quantiques, ce qui contribue à augmenter le rendement quantique interne de la portion active.

Ainsi, les fils du dispositif optoélectronique présentent chacun un rendement optique amélioré par l'effet conjugué de l'élargissement et de la passivation de la portion active. Le rendement optique correspond ici au rapport du flux lumineux émis par le dispositif optoélectronique sur la puissance électrique absorbée par le dispositif.

En effet, l'élargissement de la portion active conduit à une surface d'émission augmentée par fil et donc à un flux lumineux émis plus important. De plus, la passivation de la bordure latérale du ou des puits quantiques de la portion active permet d'augmenter le rendement quantique interne de la portion active par une limitation de l'impact des états de surface en bordure latérale des puits quantiques. En effet, les états de surface, issus par exemple de défauts structuraux ou des liaisons pendantes pouvant notamment apparaître lors de l'élargissement de la portion active, peuvent être à l'origine de recombinaisons non radiatives dans la portion active. Ainsi, la passivation de la portion active réduit le taux de recombinaisons non radiatives dans la portion active et ainsi augmente le rendement quantique interne de la portion active du fil.

L'élargissement de la portion active et la passivation de la paroi latérale de celle-ci conduisent donc à une augmentation du rendement optique de chaque fil.

La figure 2 est une vue schématique partielle d'une structure semiconductrice tridimensionnelle 2 d'un dispositif optoélectronique selon une première variante, la structure semiconductrice tridimensionnelle 2 formant une diode électroluminescente sous forme de fil en configuration axiale dont la portion active 30 comporte un unique puits quantique 32. Dans cet exemple, le fil 2 est réalisé à base de GaN et le puits quantique est en InGaN.

La portion active 30 comporte un puits quantique 32 unique réalisé dans un second matériau semiconducteur, ici de l'InGaN, comportant le même composé GaN que celui des première et seconde portions dopées 10, 20, dans lequel est incorporé un élément supplémentaire, ici de l'indium. La proportion atomique des éléments du composé formant le second matériau est de préférence sensiblement homogène au sein du puits quantique. Le puits quantique 32 unique d'InGaN forme une portion qui s'étend entre les première et seconde portions dopées 10, 20 et présente un diamètre moyen supérieur au diamètre moyen de la première portion dopée 10. Comme illustré sur la figure 2, il peut être formé de deux parties dites inférieure 32a et supérieure 32b, disposées l'une sur l'autre suivant l'axe longitudinal Δ, la partie inférieure 32a étant située entre la première portion dopée 10 et la partie supérieure 32b, et présentant un diamètre local qui augmente continûment à partir de la valeur du diamètre local de la première portion dopée 10 au niveau de la face supérieure 11. La seconde partie 32b présente un diamètre local sensiblement constant sur toute sa hauteur.

De plus, la portion active 30 comporte une couche de passivation 34 au niveau de sa paroi latérale 35, qui recouvre la bordure latérale 33 du puits quantique 32 d'InGaN, tant au niveau de la première partie 32a que de la seconde partie 32b. Elle est réalisée en un matériau identique au composé GaN des première et seconde portions dopées, ici non intentionnellement dopé. Alternativement, elle peut être formée d'AlN ou d'AlGaN, permettant ainsi d'augmenter la résistance électrique ou l'énergie de bande interdite de la couche de passivation. La couche de passivation présente ici une épaisseur comprise entre 2nm et 15nm, par exemple 5nm.

Un exemple de procédé de réalisation du dispositif optoélectronique est maintenant décrit, dans le cas où les structures semiconductrices tridimensionnelles sont identiques ou similaires à celle décrite en référence à la figure 2, dans laquelle la portion active 30 est formée d'un unique puits quantique 32. Dans cet exemple, les fils 2 sont réalisés par croissance épitaxiale par jets moléculaires (MBE, pour *Molecular Beam Epitaxy*) et sont réalisés à base de GaN.

Dans le cadre d'une épitaxie par jets moléculaires, les paramètres influençant la croissance épitaxiale sont :
- le rapport III/V nominal, défini comme le rapport entre le flux d'éléments de la colonne III sur le flux d'éléments de la colonne V, c'est-à-dire ici le rapport Ga/N lors de la croissance des première et seconde portions dopées en GaN ; et le rapport III/N, également appelé Métal/N ou (Ga+In)/N, lors de la croissance du puits quantique en InGaN ;
- le rapport In/III nominal, défini comme le rapport entre le flux de l'élément supplémentaire, ici l'indium, sur le flux des éléments de la colonne III, c'est-à-dire le gallium et l'indium ;
- la température de croissance T, mesurée ici au niveau du substrat.

Lors d'une première étape, on forme la première portion dopée 10 par croissance épitaxiale à partir de la surface de la couche de nucléation 5. Pour cela, la température de croissance est portée à une première valeur T₁, par exemple comprise entre 775°C et 850°C, par exemple 845°C. Le rapport III/V nominal, ici le rapport Ga/N, présente une valeur (III/V)₁ inférieure à 1 pour se placer en conditions dites azote riche. Elle peut être par exemple comprise entre 0,1 et 0,5. Le matériau GaN de la première portion est dopé n par du silicium. La première portion dopée n présente ici une hauteur de 1µm environ et un diamètre moyen D_{N} de 50nm environ. On obtient ainsi une première portion dopée qui présente une forme d'un fil qui s'étend suivant l'axe longitudinal Δ. Elle présente une face supérieure, opposée au substrat et orientée suivant l'axe cristallographique c, sensiblement plane.

Lors d'une seconde étape, on forme la portion active 30 par croissance épitaxiale à partir de la face supérieure 11 de la première portion 10 dopée n. Pour cela, la température de croissance est portée à une seconde valeur T₂ inférieure à la première valeur T₁, et comprise dans une gamme de température autorisant l'incorporation d'indium. Dans le cas de l'InGaN, la gamme d'incorporation d'indium est typiquement comprise entre 560°C et 690°C. A titre d'exemple, la valeur T₂ de la température est ici comprise entre 600°C et 680°C, par exemple égale à 670°C environ. Par ailleurs, le rapport In/III nominal présente une valeur (In/III)₂ comprise entre 5% et 70%, de préférence comprise entre 10% et 50%, en fonction de la composition d'InGaN recherchée, par exemple ici 28% dans le but d'obtenir une émission lumineuse dans le vert à 555nm environ.

De plus, le rapport III/N nominal présente une valeur (III/N)₂ supérieure à celle (III/V)₁ de l'étape précédente par le flux d'indium. Lors que le rapport Ga/N nominal reste constant à 0,3, la valeur (III/N)₂ est alors supérieure à 0,3. Elle peut être comprise entre 0,32 et 1,5, et de préférence être comprise entre 0,33 et 0,60 de manière à présenter une meilleure qualité cristalline et/ou un spectre d'émission dont la largeur à mi-hauteur (FWHM, pour *Full Width at Half Maximum*) du pic d'émission est réduite. Par exemple, elle est ici de 0,42. On obtient ainsi une portion active comportant un unique puits quantique en InGaN avec une proportion atomique d'indium de 28% environ, non intentionnellement dopé, susceptible d'émettre un rayonnement lumineux autour de 550nm lorsque le fil est polarisé en direct.

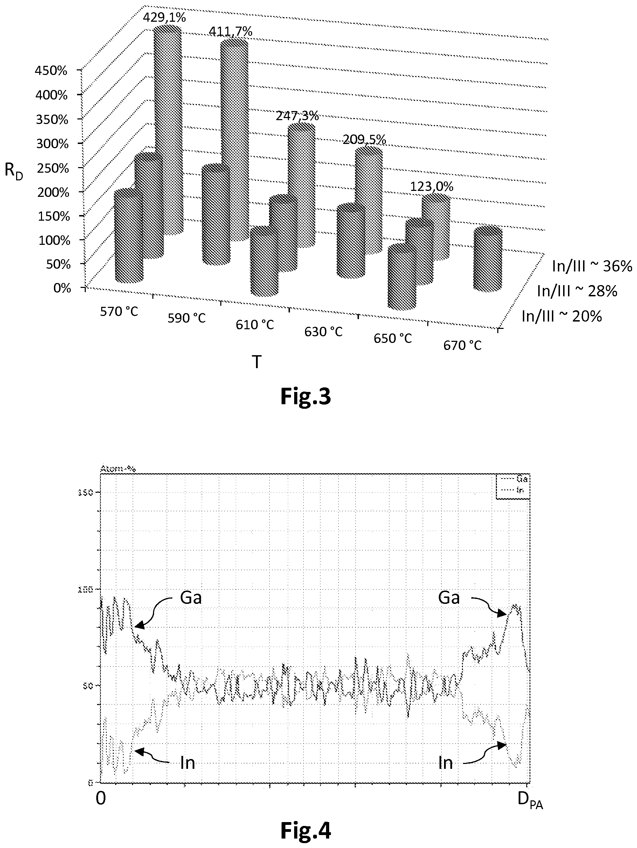

Les inventeurs ont mis en évidence que la diminution de la température de croissance, par exemple à une température comprise entre 600°C et 680°C, associée à l'augmentation du rapport III/N nominal, par exemple compris entre 0,33 et 0,60, conduit à un élargissement du diamètre moyen du puits quantique, et donc de la portion active, vis-à-vis de celui de la première portion dopée n, par exemple un élargissement compris entre 115% et 250%. Comme le montre le diagramme de la figure 3, le taux d'élargissement R_{D} = D_{PA}/D_{N}, où D_{PA} est le diamètre moyen de la portion active et D_{N} celui de la première portion dopée, dépend de la diminution de la température de croissance et de l'augmentation du rapport III/N nominal. Ainsi, à température de croissance inférieure à la valeur T₁, l'augmentation du rapport In/III nominal, et donc du rapport III/N nominal, conduit à une augmentation du taux d'élargissement R_{D}. De même, à rapport III/N nominal supérieur à la valeur (III/N)₁, la diminution de la température de croissance conduit à une augmentation du taux d'élargissement R_{D}. Ainsi, en fonction du spectre d'émission recherché qui impose une valeur du rapport III/N nominal, l'augmentation du rapport III/N nominal et/ou la diminution de la température de croissance permettent d'obtenir un taux d'élargissement R_{D} de la portion active conduisant à une augmentation du rendement optique du fil. Il apparaît également que pour une température de croissance T2 comprise entre 600°C et 680°C et un rapport (III/N)₂ compris entre 0,33 et 0,60, on obtient une diode adaptée à émettre un rayonnement lumineux dont le spectre d'émission présente, au pic d'émission, une largeur à mi-hauteur réduite.

De plus, les inventeurs ont mis en évidence que la croissance épitaxiale de la portion active 30 comportant un unique puits quantique 32 peut s'accompagner de la formation simultanée de la couche de passivation 34 entourant la bordure latérale 33 du puits quantique. Ainsi, la portion active est formée d'un unique puits quantique d'InGaN dont la bordure latérale est passivée par une couche de passivation en GaN. Comme le montre la figure 4 qui correspond à la proportion atomique d'indium et de gallium suivant un profil transversal de la portion active obtenue par analyse dispersive en énergie (EDX, pour *energy dispersive X-ray spectrometry*), une couche passivante de GaN d'une épaisseur moyenne de 5nm environ est située au niveau de la bordure latérale du puits quantique d'InGaN. La formation concomitante du puits quantique unique et de la couche de passivation permet d'augmenter le rendement quantique interne de la portion active dans la mesure où les états de surface liés aux liaisons pendantes du puits quantique, conduisant potentiellement à des recombinaisons non radiatives, sont passivés par la couche de passivation.

On obtient alors une portion active 30 élargie dont la bordure latérale 33 du puits quantique 32 est passivée, ce qui permet d'augmenter le rendement optique du fil. La portion active peut présenter une hauteur de 75nm à 100nm et un diamètre moyen de 75nm à 100nm. La couche de passivation peut présenter une épaisseur moyenne de l'ordre de 2nm à 10nm environ.

Lors d'une troisième étape, on forme la seconde portion dopée 20 par croissance épitaxiale à partir de la face supérieure 31 de la portion active 30. Pour cela, le flux d'indium est stoppé puis on augmente la valeur du rapport III/N nominal, ici le rapport Ga/N, à une valeur (III/N)₃ supérieure à celle (III/N)₂ de la deuxième étape, et de préférence supérieure à 1, par exemple égale à 4/3 environ. De plus, la température de croissance présente une valeur T₃ qui peut être égale, inférieure ou supérieure à la seconde valeur T₂, mais qui reste inférieure à la première valeur T₁, par exemple égale à 670°C environ. Cela se traduit par un élargissement de la seconde portion dopée p. Celle-ci peut présenter une hauteur de 350nm environ et un diamètre moyen de 150nm environ. La croissance de la seconde portion dopée p peut continuer jusqu'à ce qu'il y ait contact mutuel et coalescence entre les secondes portions dopées p, formant ainsi une surface supérieure sensiblement plane. On obtient ainsi un fil en configuration axiale à portion active élargie dont le puits quantique unique présente une bordure latérale passivée. Plusieurs fils peuvent ainsi être obtenus, ici en contact mutuel au niveau de leur portion dopée p respective.

Enfin, lors d'une dernière étape, la seconde électrode de polarisation 6, réalisée en un matériau électriquement conducteur et transparent au rayonnement lumineux émis par les fils, est déposée sur la surface supérieure 21 de manière à être en contact avec les secondes portions dopées 20. Ainsi, l'application d'une différence de potentiel en direct aux fils par les deux électrodes de polarisation conduit à l'émission d'un rayonnement lumineux dont les propriétés du spectre d'émission dépend de la composition du puits quantique dans les portions actives. Le rendement optique est augmenté par rapport à celui des exemples de l'art antérieur mentionnés précédemment dans la mesure où, à densité de fils équivalente, les fils selon le premier mode de réalisation présentent une portion active élargie dont le puits quantique présente une bordure latérale passivée.

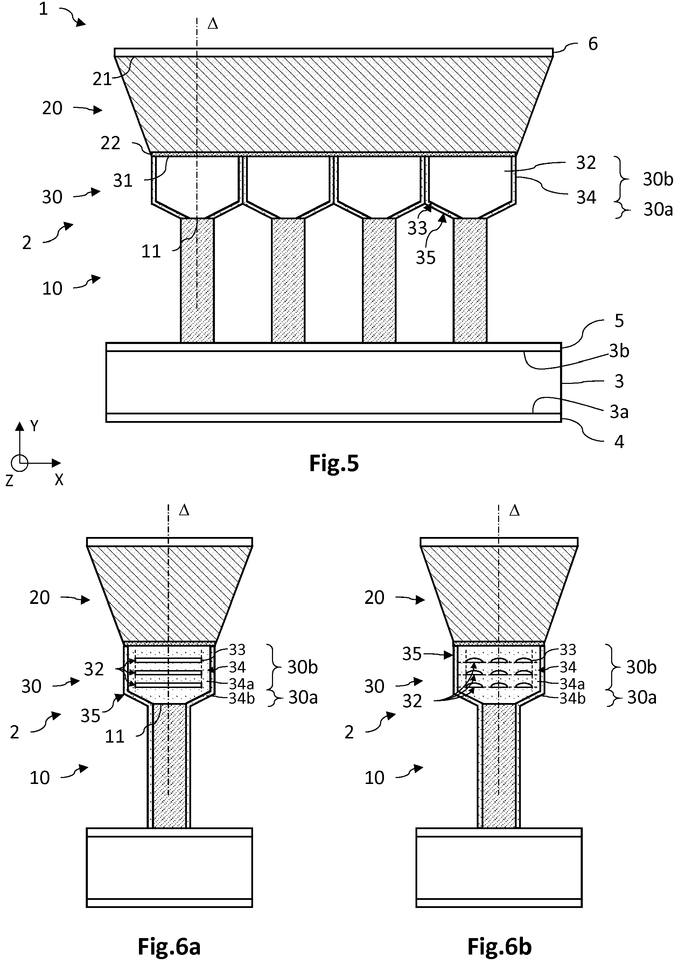

La figure 5 est une vue schématique en coupe d'un dispositif optoélectronique 1 selon un second mode de réalisation, qui se distingue de ceux représentés sur les figures 1 et 2 essentiellement en ce que les fils 2 sont en contact mutuel au niveau des portions actives 30. De manière identique au mode de réalisation de la figure 1, le dispositif optoélectronique 1 comporte un substrat 3 en un matériau semiconducteur, par exemple du silicium fortement dopé n, revêtu sur sa face avant 3b d'une couche de nucléation 5 et dont la face opposée 3a est recouverte d'une couche formant la première électrode 4 de polarisation.

Les structures semiconductrices tridimensionnelles sont ici identiques ou similaires à celle décrite en référence à la figure 2. Elles se présentent sous forme de fils en configuration axiale qui s'étendent à partir de la couche de nucléation suivant l'axe longitudinal Δ orienté de manière sensiblement orthogonale au plan (X,Y) de la face avant du substrat, chaque fil 2 comportant une première portion dopée 10 en contact avec la couche de nucléation 5, une portion active 30 ainsi qu'une seconde portion dopée 20 disposées dans le prolongement de la première portion dopée 10 suivant l'axe longitudinal Δ.

La portion active 30 comporte ici un puits quantique 32 unique de diamètre moyen supérieur à celui de la première portion dopée 10, dont la bordure latérale 33 est recouverte d'une couche de passivation 34. Dans cet exemple, la portion active 30 comporte un unique puits quantique en InGaN ainsi qu'une couche passivante en GaN.

Les fils 2 sont en contact mutuel au niveau des portions actives 30, de sorte que chaque portion active est en contact avec une ou plusieurs portions actives adjacentes. On parle également de coalescence des fils au niveau des portions actives. Plus précisément, les portions actives 30 sont en contact mutuel au niveau des couches de passivation 34, le puits quantique 32 de chaque portion active étant alors séparé du puits quantique 32 de la portion active adjacente par les couches de passivation 34 en contact mutuel. Les premières portions dopées 10 ne sont pas en contact mutuel et sont distinctes les unes des autres.

Chaque portion active 30 comporte ici une première partie 30a qui s'étend à partir de la première portion dopée 10 suivant l'axe longitudinal Δ, dont le diamètre local du puits quantique 32 croît jusqu'à ce que la couche de passivation 34 recouvrant la bordure latérale 33 du puits quantique rejoigne la couche de passivation 34 de la portion active du fil 2 adjacent. Une seconde partie 30b s'étend ensuite à partir de la première partie 30a, dans laquelle le puits quantique 32 présente un diamètre local sensiblement constant suivant l'axe longitudinal Δ, celui-ci étant séparé du puits quantique 32 voisin par les couches de passivation 34 en contact mutuel, le long de l'axe longitudinal Δ.

Le dispositif optoélectronique comporte également des secondes portions dopées 20 en contact mutuel dès la face supérieure 31 des portions actives. Les secondes portions dopées 20 se distinguent ainsi de celles décrites en référence à la figure 1 en ce qu'elles forment une couche dopée p qui recouvre continûment l'ensemble des portions actives 30. Elle présente ici une épaisseur sensiblement homogène suivant les dimensions latérales du dispositif optoélectronique dans le plan (X,Y). La couche dopée p comporte ici une couche de blocage d'électrons 22 située à l'interface avec les portions actives 30. La face supérieure 21 de la couche dopée p est recouverte de l'électrode de polarisation 6.

Ainsi, la coalescence des fils 2 au niveau des portions actives 30, et non plus uniquement au niveau des secondes portions dopées 20, conduit à optimiser la surface d'émission du dispositif optoélectronique par unité de surface du substrat. Par ailleurs, le ou les puits quantiques 32 de chaque portion active 30 étant séparés du ou des puits quantiques 32 de la portion active 30 adjacente par les couches de passivation 34 en contact mutuel, on limite ainsi les recombinaisons non radiatives au niveau du joint de grain formé par la coalescence des couches de passivation, augmentant ainsi le rendement quantique interne de chaque fil. Le rendement optique du dispositif optoélectronique est alors optimisé.

Un exemple de procédé de réalisation du dispositif optoélectronique selon le mode de réalisation illustré sur la figure 5 est maintenant décrit. Dans cet exemple, les fils 2 sont réalisés par croissance épitaxiale par jets moléculaires (MBE, pour *Molecular Beam Epitaxy*) et sont réalisés à base de GaN. Chaque portion active 30 comporte un puits quantique 32 unique en InGaN et les couches de passivation 34 sont ici réalisées en GaN. Comme mentionné précédemment, les couches de passivation peuvent ici être réalisées en d'autres matériaux III-N, tels que l'AlN ou l'AlGaN.

La coalescence des portions actives 30 des fils est obtenue par l'ajustement de la densité des premières portions dopées 10 par unité de surface du substrat, ou densité surfacique, ainsi que par l'ajustement du taux d'élargissement R_{D} des portions actives 30.

La première étape de formation des premières portions dopées 10 par croissance épitaxiale est similaire à celle décrite précédemment, à la différence près que, dans un premier temps, la température de croissance et le rapport III/V nominal, ici Ga/N, sont ajustés pour obtenir une densité surfacique suffisante de premières portions dopées. A titre d'exemple, une valeur initiale T₁ de température de croissance égale à 840°C à 5% près, associée à une valeur initiale (III/V)₁ de 0,5 du rapport Ga/N nominal conduisent à une densité surfacique de premières portions dopées comprise entre 0,5.10¹⁰ cm⁻² et 1,5.10¹⁰ cm⁻², par exemple sensiblement égale à 1,0.10¹⁰ cm⁻². Une telle densité surfacique des premières portions dopées permet alors d'obtenir des premières portions actives de bonne qualité cristalline et suffisamment espacées les unes des autres, tout en permettant ensuite la coalescence des portions actives. Dans un second temps, la valeur (III/V)₁ du rapport Ga/N nominal peut être maintenue ou diminuée à une valeur de l'ordre de 0,3, et la valeur T₁ de la température de croissance peut être maintenue. La croissance épitaxiale des premières portions dopées suivant l'axe longitudinal Δ est alors réalisée.

La seconde étape de formation des portions actives 30 par croissance épitaxiale est similaire à celle décrite précédemment, à la différence près que la température de croissance et le rapport III/V, ici Métal/N, sont ajustés pour obtenir un taux d'élargissement R_{D} suffisant pour assurer la coalescence des portions actives. A titre d'exemple, un taux d'élargissement supérieur ou égal à 115%, et par exemple compris entre 115% et 250% permet d'obtenir la coalescence des portions actives, notamment lorsque la densité surfacique des premières portions dopées est comprise entre 0,5.10¹⁰cm⁻² et 1,5.10¹⁰cm⁻². Ainsi, une valeur T₂ de la température de croissance comprise entre 600°C et 680°C associée à une valeur (III/V)₂ du rapport Métal/N comprise entre 0,33 et 0,60 assure la coalescence de portions actives de bonne qualité cristalline tout en optimisant l'homogénéité de la proportion atomique d'indium incorporé au sein de chaque portion active. On obtient ainsi des portions actives 30 en contact mutuel, dont chaque puits quantique 32 unique d'InGaN est séparé du puits quantique 32 de la portion active 30 adjacente par les couches de passivation 34 en contact mutuel. Les faces supérieures 31 des portions actives 30 forment ainsi une surface sensiblement plane sur laquelle peut être déposée une couche dopée 20.

La troisième étape de formation des secondes portions dopées 20 par croissance épitaxiale est identique ou similaire à celle décrite précédemment. On stoppe le flux d'indium puis on augmente la valeur du rapport III/N nominal, ici redevenu Ga/N, à une valeur (III/N)₃ supérieure ou égale à celle (III/N)₂ de la deuxième étape, et de préférence supérieure à 1, par exemple égale à 4/3 environ. De plus, la température de croissance T₃ peut être égale, inférieure ou supérieure à la seconde valeur T₂, mais reste ici inférieure à la première valeur T₁, par exemple égale à 670°C environ. On obtient ainsi une couche dopée p qui recouvre continûment les portions actives des fils et présente une épaisseur sensiblement constante.

Enfin, on dépose une couche d'électrode de polarisation 6 sur la face supérieure 21 de la couche dopée 20. L'application d'une différence de potentiel aux fils en direct par l'intermédiaire des électrodes de polarisation conduit à l'émission d'un rayonnement lumineux par les fils dont le rendement optique est optimisé.

La figure 6a est une vue schématique et partielle d'une coupe d'une structure semiconductrice tridimensionnelle d'un dispositif optoélectronique en configuration filaire et axiale. La structure semiconductrice tridimensionnelle est similaire à celle décrite en référence à la figure 2 et s'en distingue essentiellement en ce que la portion active 30 comporte des puits quantiques 32 multiples sous forme d'une alternance de couches formant les puits quantiques, et de couches barrières.

Dans cet exemple, le fil 2 comporte une première portion dopée 10 sur laquelle s'étend suivant l'axe longitudinal Δ une portion active 30 comportant trois couches 32 de puits quantiques insérées entre des couches barrières. Une seconde portion dopée 20 s'étend suivant l'axe longitudinal Δ sur la portion active 30. Le fil 2 est ici obtenu par épitaxie par jets moléculaires et réalisé à base de GaN, les couches formant les puits quantiques étant ici en InGaN.

La portion active 30 comporte ici une première partie 30a de couche barrière en GaN qui s'étend à partir de la première portion dopée 10 suivant l'axe longitudinal Δ, dont le diamètre local du puits quantique croît d'une première valeur sensiblement égale à celle du diamètre local de la première portion dopée 10 au niveau de sa face supérieure 11, jusqu'à une seconde valeur. Une seconde partie 30b s'étend ensuite à partir de la première partie 30a, et comporte les trois puits quantiques 32 qui présentent chacun un diamètre local sensiblement identique.

Chaque puits quantique 32 est recouvert au niveau de sa bordure latérale 33 d'une couche de passivation 34, ici en GaN, voire en AlN ou en AlGaN. Cette couche de passivation 34 présente une épaisseur supérieure ou égale à 2nm et avantageusement comprise entre 2nm et 15nm. Dans cet exemple, la couche de passivation 34 comporte une première partie latérale 34a, en contact avec la bordure latérale 33 des puits quantiques, obtenue simultanément à la formation des puits quantiques. Elle comporte avantageusement une seconde partie latérale 34b, qui recouvre la première partie de passivation 34a et forme la paroi latérale 35 de la portion active. Cette seconde partie de passivation 34b est formée de manière distincte à l'étape de formation des puits quantiques. Cette seconde partie de passivation 34b forme ainsi la paroi latérale 35 de la portion active et peut recouvrir la bordure latérale de la première portion dopée 10.

La formation épitaxiale de la première partie 30a de la portion active 30 peut être obtenue en diminuant la température de croissance à une valeur T₂ inférieure à la valeur T₁ de croissance de la première portion dopée, par exemple comprise entre 600°C et 800°C, par exemple 670°C. De plus, le rapport III/V nominal, ici le rapport Ga/N, présente une valeur (III/V)₂ supérieure à la valeur (III/V)₁ de croissance de la première portion dopée. On forme ainsi la première partie 30a de la portion active 30, en GaN, dont le diamètre local maximal dépend des valeurs de la température et du rapport III/V nominal. La portion active présente ensuite un diamètre local sensiblement contant.

La formation épitaxiale des couches 32 formant les puits quantiques est obtenue en introduisant un flux d'indium selon une valeur du rapport In/III nominal comprise entre 5% et 70%, et de préférence comprise entre 10% et 50%, en fonction des propriétés optiques d'émission recherchées du fil. On forme ainsi une alternance de couches formant les puits quantiques en InGaN et de couches barrières en GaN. Concomitamment à la formation des puits quantiques, une couche de passivation 34, ici en GaN, est formée à la bordure latérale 33 des puits quantiques 32.

Une étape facultative de formation d'une seconde partie latérale 34b de couche de passivation 34 peut ensuite être effectuée, au cours de laquelle le flux d'indium est stoppé. La température de croissance peut être sensiblement égale voire supérieure à la valeur correspondant à la croissance de la portion active. La valeur du rapport III/N nominal est par exemple sensiblement égale à 1,5. La seconde partie latérale de la couche de passivation recouvre la première partie de la couche de passivation et peut également recouvrir la bordure latérale de la première portion dopée n.

On forme ensuite la seconde portion dopée 20 munie d'une couche de blocage d'électrons, à partir des conditions opératoires décrites précédemment.

De manière similaire au mode de réalisation décrit en référence à la figure 5, le dispositif optoélectronique peut comporter une pluralité de structures semiconductrices tridimensionnelles 2 en contact mutuel au niveau des portions actives 30. Les puits quantiques 32 d'une même portion active 30 étant alors séparés des puits quantiques 32 de la portion active adjacente par la première partie latérale 34a de la couche de passivation 34.

La figure 6b est une vue schématique et partielle d'une coupe d'une autre structure semiconductrice tridimensionnelle d'un dispositif optoélectronique en configuration filaire et axiale. La structure semiconductrice tridimensionnelle est similaire à celle décrite en référence à la figure 6a et s'en distingue essentiellement en ce que la portion active 30 comporte des puits quantiques 32 multiples sous forme de boîtes quantiques intercalés suivant l'axe longitudinal entre des couches barrières.

Une telle structure semiconductrice tridimensionnelle peut être obtenue suivant le procédé décrit précédemment en référence à la variante de la figure 6a, et s'en distingue essentiellement en ce que le rapport In/III présente une valeur supérieure à une valeur seuil, cette valeur étant approximativement égale à 20% dans le cas de puits quantiques d'InGaN reposant sur une couche barrière de GaN.

De manière similaire au mode de réalisation décrit en référence à la figure 5, le dispositif optoélectronique peut comporter une pluralité de structures semiconductrices tridimensionnelles en contact mutuel au niveau des portions actives. Les boîtes quantiques d'une même portion active étant alors séparées des boîtes quantiques de la portion active adjacente par la première partie latérale de la couche de passivation.

Des modes de réalisation particuliers viennent d'être décrits. Différentes variantes et modifications apparaîtront à l'homme du métier.

On a décrit des structures semiconductrices tridimensionnelles adaptées à émettre un rayonnement lumineux à partir d'un signal électrique, formant ainsi des diodes électroluminescentes. Alternativement, les structures peuvent être adaptées à détecter un rayonnement lumineux incident et à produire en réponse un signal électrique, formant ainsi une photodiode. Les applications peuvent concerner le domaine de l'optoélectronique ou du photovoltaïque.

## Revendications

1. Dispositif optoélectronique (1) comportant au moins une structure semiconductrice tridimensionnelle (2) s'étendant suivant un axe longitudinal (Δ) sensiblement orthogonal à un plan d'un substrat (3) sur lequel elle repose, et comportant :
- une première portion dopée (10), s'étendant à partir d'une face du substrat (3) suivant l'axe longitudinal (Δ) ;
- une portion active (30) comportant au moins un puits quantique (32), s'étendant à partir de la première portion dopée (10) suivant l'axe longitudinal (Δ), et comportant une couche de passivation (34) ;
- une seconde portion dopée (20), s'étendant à partir de la portion active (30) suivant l'axe longitudinal (Δ) ;
**caractérisé en ce que** le puits quantique (32) de la portion active (30) présente un diamètre moyen supérieur à celui de ladite première portion dopée (10), et est recouvert latéralement par la couche de passivation (34), et **en ce que** le dispositif optoélectronique comporte une pluralité de structures semiconductrices tridimensionnelles (2) s'étendant de manière sensiblement parallèle les unes aux autres, de manière à ce qu'il y a coalescence des structures semiconductrices tridimensionnelles (2) au niveau des portions actives (30) de sorte que les couches de passivation (34) des portions actives (30) sont en contact mutuel.

2. Dispositif optoélectronique (1) selon la revendication 1, dans lequel le ou les puits quantiques (32) de chaque portion active (30) sont séparés du ou des puits quantiques (32) de la portion active (30) adjacente par les couches de passivation (34) en contact mutuel.

3. Dispositif optoélectronique (1) selon la revendication 1 ou 2, présentant une densité de premières portions dopées (10) par unité de surface du substrat (3) comprise entre 0,5.10¹⁰ cm⁻² et 1,5.10¹⁰ cm⁻², les premières portions dopées (10) étant distinctes les unes des autres et présentant un diamètre moyen sensiblement constant suivant l'axe longitudinal (Δ).

4. Dispositif optoélectronique (1) selon l'une quelconque des revendications 1 à 3, la couche de passivation (34) présentant une épaisseur moyenne supérieure ou égale à 2nm, et de préférence comprise entre 2nm et 15nm.

5. Dispositif optoélectronique (1) selon l'une quelconque des revendications 1 à 4, la première portion dopée (10) étant réalisée en un composé III-V, un composé II-VI, ou un élément ou composé IV, la couche de passivation (34) étant réalisée en un composé comportant au moins un élément présent dans le composé de la première portion dopée.

6. Dispositif optoélectronique (1) selon l'une quelconque des revendications 1 à 5, le diamètre moyen du ou des puits quantiques (32) étant compris entre 115% et 250% du diamètre moyen de la première portion dopée (10).

7. Dispositif optoélectronique (1) selon l'une quelconque des revendications 1 à 6, la portion active (30) comportant un unique puits quantique (32) s'étendant continûment entre les première et seconde portions dopées (10, 20), et ledit unique puits quantique (32) étant recouvert latéralement par la couche de passivation (34).

8. Dispositif optoélectronique (1) selon l'une quelconque des revendications 1 à 6, dans lequel la portion active (30) comporte plusieurs couches (32) formant des puits quantiques ou boîtes quantiques intercalées entre des couches barrières, recouvertes latéralement par la couche de passivation (34).

9. Dispositif optoélectronique (1) selon l'une quelconque des revendications 1 à 8, la structure semiconductrice tridimensionnelle (2) étant réalisée en un matériau comportant majoritairement un composé III-N, la couche de passivation (34) étant de préférence réalisée en un composé choisi parmi le GaN, l'AlGaN et l'AlN.

10. Procédé de réalisation d'un dispositif optoélectronique (1) selon l'une quelconque des revendications précédentes, dans lequel les structures semiconductrices tridimensionnelles (2) sont formées par épitaxie par jets moléculaires.

11. Procédé selon la revendication 10, comportant des étapes de formation par croissance épitaxiale d'une pluralité de structures semiconductrices tridimensionnelles (2) dans lesquelles :
i) on forme les premières portions dopées (10), qui s'étendent à partir d'une face du substrat (3) suivant l'axe longitudinal (Δ) ;
ii) on forme les portions actives (30) comportant au moins un puits quantique (32), qui s'étendent à partir des premières portions dopées suivant l'axe longitudinal (Δ) ;
**caractérisé en ce que** :
- lors de l'étape ii), le puits quantique (32) de chaque portion active (30) est formé de manière à présenter un diamètre moyen supérieur à celui de la première portion dopée (10) ;
- on forme en outre une couche de passivation (34) recouvrant latéralement le puits quantique (32).

12. Procédé selon la revendication 11, dans lequel la formation de la couche de passivation (34) est concomitante à la formation du puits quantique (32).

13. Procédé selon l'une quelconque des revendications 10 à 12, la structure semiconductrice tridimensionnelle (2) comportant majoritairement un composé III-V, dans lequel l'étape ii) de formation de la portion active (30) est effectuée à une valeur (T₂) de température de croissance épitaxiale inférieure à une valeur (T₁) lors de l'étape i) de formation de la première portion dopée, et de préférence comprise entre 600°C et 680°C, et est effectuée à un rapport entre les flux atomiques des éléments III sur les éléments V compris entre 0,33 et 0,60.

14. Procédé selon la revendication 13, dans lequel l'étape i) de formation de la première portion dopée (10) comporte une sous-étape de nucléation du composé III-V effectuée à une température de croissance de telle sorte qu'une densité de premières portions dopées (10) par unité de surface du substrat est comprise entre 0,5.10¹⁰ cm⁻² et 1,5.10¹⁰ cm⁻².

## Patentansprüche

1. Optoelektronische Vorrichtung (1), umfassend mindestens eine dreidimensionale Halbleiterstruktur (2), die sich entlang einer Längsachse (Δ) im Wesentlichen orthogonal zu einer Ebene eines Substrats (3), auf dem sie aufliegt, erstreckt, und umfassend:
- einen ersten dotierten Abschnitt (10), der sich von einer Seite des Substrats (3) aus entlang der Längsachse (Δ) erstreckt;
- einen aktiven Abschnitt (30), umfassend mindestens einen Quantentopf (32), der sich von dem ersten dotierten Abschnitt (10) entlang der Längsachse (Δ) erstreckt und eine Passivierungsschicht (34) umfasst;
- einen zweiten dotierten Abschnitt (20), der sich von dem aktiven Abschnitt (30) entlang der Längsachse (Δ) erstreckt;
**dadurch gekennzeichnet, dass** der Quantentopf (32) des aktiven Abschnitts (30) einen größeren durchschnittlichen Durchmesser als jener des ersten dotierten Abschnitts (10) aufweist und seitlich von der Passivierungsschicht (34) bedeckt ist, und
dass die optoelektronische Vorrichtung eine Vielzahl von dreidimensionalen Halbleiterstrukturen (2) umfasst, die sich im Wesentlichen parallel zueinander erstrecken, so dass es zu einer Koaleszenz der dreidimensionalen Halbleiterstrukturen (2) im Bereich der aktiven Abschnitte (30) kommt, so dass die Passivierungsschichten (34) der aktiven Abschnitte (30) in wechselseitigem Kontakt sind.

2. Optoelektronische Vorrichtung (1) nach Anspruch 1, bei der der oder die Quantentöpfe (32) jedes aktiven Abschnitts (30) von dem oder den Quantentöpfen (32) des angrenzenden aktiven Abschnitts (30) durch die Passivierungsschichten (34) in wechselseitigem Kontakt getrennt sind.

3. Optoelektronische Vorrichtung (1) nach einem der Ansprüche 1 oder 2, die eine Dichte von ersten dotierten Abschnitten (10) pro Flächeneinheit des Substrats (3) zwischen 0,5.10¹⁰ cm⁻² und 1,5.10¹⁰ cm⁻² aufweist, wobei die ersten dotierten Abschnitte (10) voneinander unterschieden sind und einen im Wesentlichen entlang der Längsachse (Δ) konstanten durchschnittlichen Durchmesser aufweisen.

4. Optoelektronische Vorrichtung (1) nach einem der Ansprüche 1 bis 3, wobei die Passivierungsschicht (34) eine durchschnittliche Dicke größer oder gleich 2 nm und vorzugsweise zwischen 2 nm und 15 nm aufweist.

5. Optoelektronische Vorrichtung (1) nach einem der Ansprüche 1 bis 4, wobei der erste dotierte Abschnitt (10) aus einer Verbindung III-V, einer Verbindung II-VI oder einem Element oder einer Verbindung IV hergestellt ist, wobei die Passivierungsschicht (34) aus einer Verbindung hergestellt ist, umfassend mindestens ein Element, das in der Verbindung des ersten dotierten Abschnitts vorhanden ist.

6. Optoelektronische Vorrichtung (1) nach einem der Ansprüche 1 bis 5, wobei der durchschnittliche Durchmesser des oder der Quantentöpfe (32) zwischen 115 % und 250 % des durchschnittlichen Durchmessers des ersten dotierten Abschnitts (10) beträgt.

7. Optoelektronische Vorrichtung (1) nach einem der Ansprüche 1 bis 6, wobei der aktive Abschnitt (30) einen einzigen Quantentopf (32) umfasst, der sich kontinuierlich zwischen den ersten und zweiten dotierten Abschnitten (10, 20) erstreckt, und wobei der einzige Quantentopf (32) seitlich mit der Passivierungsschicht (34) bedeckt ist.

8. Optoelektronische Vorrichtung (1) nach einem der Ansprüche 1 bis 6, bei der der aktive Abschnitt (30) mehrere Schichten (32) umfasst, die Quantentöpfe oder Quantenpunkte bilden, die zwischen Barriereschichten zwischengefügt sind, die seitlich mit der Passivierungsschicht (34) bedeckt sind.

9. Optoelektronische Vorrichtung (1) nach einem der Ansprüche 1 bis 8, wobei die dreidimensionale Halbleiterstruktur (2) aus einem Material hergestellt ist, umfassend mehrheitlich eine Verbindung III-N, wobei die Passivierungsschicht (34) vorzugsweise aus einer Verbindung hergestellt ist, die unter GaN, AIGaN und AlN ausgewählt ist.

10. Verfahren zur Herstellung einer optoelektronischen Vorrichtung (1) nach einem der vorhergehenden Ansprüche, bei dem die dreidimensionalen Halbleiterstrukturen (2) durch Epitaxie durch Molekularstrahlen gebildet sind.

11. Verfahren nach Anspruch 10, umfassend Schritte der Bildung einer Vielzahl von dreidimensionalen Halbleiterstrukturen (2) durch epitaxiales Wachstum, bei denen:
i) die ersten dotierten Abschnitte (10) gebildet werden, die sich von einer Seite des Substrats (3) entlang der Längsachse (Δ) erstrecken;
ii) die aktiven Abschnitte (30), umfassend mindestens einen Quantentopf (32), gebildet werden, die sich von den ersten dotierten Abschnitten aus entlang der Längsachse (Δ) erstrecken;
**dadurch gekennzeichnet, dass**:
- bei dem Schritt ii) der Quantentopf (32) jedes aktiven Abschnitts (30) derart gebildet wird, dass er einen größeren durchschnittlichen Durchmesser als jener des ersten dotierten Abschnitts (10) aufweist;
- ferner eine Passivierungsschicht (34) gebildet wird, die den Quantentopf (32) seitlich bedeckt.

12. Verfahren nach Anspruch 11, bei dem die Bildung der Passivierungsschicht (34) mit der Bildung des Quantentopfes (32) einhergeht.

13. Verfahren nach einem der Ansprüche 10 bis 12, wobei die dreidimensionale Halbleiterstruktur (2) mehrheitlich eine Verbindung III-V umfasst, bei dem der Schritt ii) der Bildung des aktiven Abschnitts (30) bei einem Temperaturwert (T₂) eines epitaxialen Wachstums unter einem Wert (T₁) bei dem Schritt i) der Bildung des ersten dotierten Abschnitts und vorzugsweise zwischen 600 °C und 680 °C und bei einem Verhältnis zwischen den atomaren Flüssen der Elemente III zu den Elementen V zwischen 0,33 und 0,60 durchgeführt wird.

14. Verfahren nach Anspruch 13, bei dem der Schritt i) der Bildung des ersten dotierten Abschnitts (10) einen Unterschritt der Nukleation der Verbindung III-V umfasst, der bei einer derartigen Wachstumstemperatur durchgeführt wird, dass eine Dichte von ersten dotierten Abschnitten (10) pro Flächeneinheit des Substrats zwischen 0,5.10¹⁰ cm⁻² und 1,5.10¹⁰ cm⁻² beträgt.

## Claims

1. Optoelectronic device (1) comprising at least one three-dimensional semiconductor structure (2) extending along a longitudinal axis (Δ) substantially orthogonal to a plane of a substrate (3) on which it lies, and comprising:
- a first doped portion (10), extending from a face of the substrate (3) along the longitudinal axis (Δ);
- an active portion (30) comprising at least one quantum well (32), extending from the first doped portion (10) along the longitudinal axis (Δ), and comprising a passivating layer (34);
- a second doped portion (20), extending from the active portion (30) along the longitudinal axis (Δ);
**characterized in that** the quantum well (32) of the active portion (30) has an average diameter greater than that of said first doped portion (10), and is covered laterally by the passivating layer (34), and **in that** the optoelectronic device comprises a plurality of three-dimensional semiconductor structures (2) extending substantially parallel to one another, such that there is coalescence of the three-dimensional semiconductor structures (2) at the active portions so that the passivating layers (34) of the active portions (30) are in mutual contact.

2. Optoelectronic device (1) according to Claim 1, in which the quantum well or wells (32) of each active portion (30) are separated from the quantum well or wells (32) of the adjacent active portion (30) by the passivating layers (34) in mutual contact.

3. Optoelectronic device (1) according to Claim 1 or 2, having a density of first doped portions (10) per unit area of the substrate (3) between 0.5×10¹⁰ cm⁻² and 1.5×10¹⁰ cm⁻², the first doped portions (10) being separate from one another and having an average diameter that is substantially constant along the longitudinal axis (Δ).

4. Optoelectronic device (1) according to any one of Claims 1 to 3, the passivating layer (34) having an average thickness greater than or equal to 2nm, and preferably between 2nm and 15nm.

5. Optoelectronic device (1) according to any one of Claims 1 to 4, the first doped portion (10) being made of a III-V compound, a II-VI compound, or a IV element or compound, the passivating layer (34) being made of a compound comprising at least one element present in the compound of the first doped portion.

6. Optoelectronic device (1) according to any one of Claims 1 to 5, the average diameter of the quantum well or wells (32) being between 115% and 250% of the average diameter of the first doped portion (10).

7. Optoelectronic device (1) according to any one of Claims 1 to 6, the active portion (30) comprising a single quantum well (32) extending continuously between the first and second doped portions (10, 20), and said single quantum well (32) being covered laterally by the passivating layer (34).

8. Optoelectronic device (1) according to any one of Claims 1 to 6, in which the active portion (30) comprises several layers (32) forming quantum wells or quantum dots inserted between barrier layers, covered laterally by the passivating layer (34).

9. Optoelectronic device (1) according to any one of Claims 1 to 8, the three-dimensional semiconductor structure (2) being made of a material comprising predominantly a III-N compound, the passivating layer (34) preferably being made of a compound selected from GaN, AIGaN and AIN.

10. Method for making an optoelectronic device (1) according to any one of the preceding claims, in which the three-dimensional semiconductor structures (2) are formed by molecular beam epitaxy.

11. Method according to Claim 10, comprising steps of formation, by epitaxial growth, of a plurality of three-dimensional semiconductor structures (2) in which:
i. the first doped portions (10), which extend from a face of the substrate (3) along the longitudinal axis (Δ), are formed;
ii. the active portions (30) comprising at least one quantum well (32), which extend from the first doped portions along the longitudinal axis (Δ), are formed;
**characterized in that**:
- in step ii), the quantum well (32) of each active portion (30) is formed so as to have an average diameter greater than that of the first doped portion (10);
- in addition, a passivating layer (34) is formed, covering the quantum well (32) laterally.

12. Method according to Claim 11, in which formation of the passivating layer (34) is concomitant with formation of the quantum well (32).

13. Method according to any one of Claims 10 to 12, the three-dimensional semiconductor structure (2) predominantly comprising a III-V compound, in which step ii) of formation of the active portion (30) is carried out at a value (T2) of temperature of epitaxial growth below a value (T1) in step i) of formation of the first doped portion, and preferably between 600°C and 680°C, and is performed at a ratio of the atomic flux of the III elements to the V elements between 0.33 and 0.60.

14. Method according to Claim 13, in which step i) of formation of the first doped portion (10) comprises a substep of nucleation of the III-V compound performed at a temperature of growth such that a density of first doped portions (10) per unit area of the substrate is between 0.5×10¹⁰ cm⁻² and 1.5×10¹⁰ cm⁻².
